# EUROPEAN PATENT APPLICATION

(11) **EP 4 496 449 A1**
(43) Date of publication of application: **22.01.2025**
(21) Application number: 23770280.8
(22) Date of filing: 20.02.2023
(51) Int. Cl.: H10K 30/50, H10K 30/40

(54) **PHOTOELECTRIC CONVERSION MATERIAL AND PHOTOELECTRIC CONVERSION ELEMENT USING SAME**

(30) Priority: 18.03.2022 JP 2022044663
(71) Applicant: PANASONIC INTELLECTUAL PROPERTY MANAGEMENT CO., LTD., Kadoma-shi, Osaka 571-0057 (JP)
(72) Inventor: OKUMURA, Hiroko, Kadoma-shi, Osaka 571-0057 (JP)
(74) Representative: Grünecker Patent- und Rechtsanwälte PartG mbB
(86) International application number: PCT/JP2023/006032
(87) International publication number: WO 2023/176321

(57) **Abstract**

A photoelectric conversion material of the present disclosure includes a perovskite compound and an ammonium salt. The ammonium salt may include at least one selected from the group consisting of an alkyl group and an aryl group. The ammonium salt may include a quaternary ammonium salt. A photoelectric conversion element 100 of the present disclosure includes a first electrode 2, a photoelectric conversion layer 4, and a second electrode 6 in this order. The photoelectric conversion layer 4 includes the photoelectric conversion material of the present disclosure.

## Description

### TECHNICAL FIELD

The present invention relates to a photoelectric conversion material and a photoelectric conversion element using the same.

### BACKGROUND ART

Non Patent Literature 1 discloses a technique of forming a layer made of CsPbI₃ and then forming a layer made of tetrabutylammonium iodide (TBAI) thereon so that a TBAPbI₃ protective layer is formed on a surface of a layer made of CsPbI₃.

### CITATION LIST

### Non Patent Literature

Non Patent Literature 1: Xiamomin Liu, and seven others, Angewandte Chemie, 2021, vol.133, p.12459-12463

### SUMMARY OF INVENTION

### Technical Problem

The present disclosure aims to provide a novel photoelectric conversion material capable of improving photoelectric conversion efficiency.

### Solution to Problem

The photoelectric conversion material of the present disclosure includes a perovskite compound and an ammonium salt.

### Advantageous Effects of Invention

The present disclosure provides a novel photoelectric conversion material capable of improving photoelectric conversion efficiency.

### BRIEF DESCRIPTION OF DRAWINGS

FIG. 1A shows a molecular structure of tetrapropylammonium iodide, which is an example of quaternary ammonium salt that can be used as an ammonium salt in a photoelectric conversion material of a first embodiment.
FIG. 1B shows a molecular structure of tetrabutylammonium iodide, which is another example of quaternary ammonium salt that can be used as an ammonium salt in the photoelectric conversion material of the first embodiment.
FIG. 1C shows a molecular structure of tetraamylammonium iodide, which is still another example of quaternary ammonium salt that can be used as an ammonium salt in the photoelectric conversion material of the first embodiment.
FIG. 2 is a cross-sectional view showing a schematic configuration of a photoelectric conversion element 100 of a second embodiment.
FIG. 3A is a graph showing I-V characteristics of photoelectric conversion elements of Example 1 and Comparative Example 1.
FIG. 3B is a graph showing I-V characteristics of photoelectric conversion elements of Example 2 and Comparative Example 2.
FIG. 3C is a graph showing an I-V characteristic of a photoelectric conversion element of Comparative Example 3.
FIG. 4 is a graph showing an increase of an open-circuit voltage (Voc), which is caused by addition of tetrabutylammonium iodide to CsSnI₃.
FIG. 5 is a graph showing I-V characteristics of photoelectric conversion elements of Comparative Examples 1, 2, and 4 to 6.
FIG. 6 is a graph showing I-V characteristics of photoelectric conversion elements of Example 1, Example 3, Example 4, and Comparative Example 1.
FIG. 7 is a graph showing I-V characteristics of photoelectric conversion elements of Example 2, Example 5, Example 6, Comparative Example 1, and Comparative Example 2.
FIG. 8 is a graph showing I-V characteristics in Examples 7 to 10.
FIG. 9 is a graph showing a photoluminescence (PL) spectrum of a single photoelectric conversion layer made of CsSnI₃ + 16 mol% SnF₂.
FIG. 10 is a graph showing a PL spectrum of a single photoelectric conversion layer made of CsSnI₃ +16 mol% SnF₂ + 5 mol% butylammonium iodide.
FIG. 11 is a graph showing a PL lifetime of a single photoelectric conversion layer made of CsSnI₃ + 16 mol% SnF₂.
FIG. 12 is a graph showing a PL lifetime of a single photoelectric conversion layer made of CsSnI₃ + 16 mol% SnF₂ + 5 mol% butylammonium iodide.
FIG. 13 is a SEM (scanning electron microscope) photograph taken from above of a photoelectric conversion layer made of CsSnI₃ + 16 mol% SnF₂.
FIG. 14 is a SEM photograph taken from above of a photoelectric conversion layer made of CsSnI₃ + 16 mol% SnF₂ + 5 mol% butylammonium iodide.

### DESCRIPTION OF EMBODIMENTS

Hereinafter, embodiments of the present disclosure will be described with reference to the attached drawings.

### (First embodiment)

A photoelectric conversion material of a first embodiment includes a perovskite compound and an ammonium salt.

With this configuration, the photoelectric conversion efficiency of the photoelectric conversion material can be improved.

The photoelectric conversion material of the first embodiment may be, for example, a mixture of a perovskite compound and an ammonium salt. In the photoelectric conversion material of the first embodiment, the perovskite compound and the ammonium salt may be mixed entirely uniformly. Therefore, with this configuration, the photoelectric conversion efficiency of the photoelectric conversion material of the first embodiment can be improved further. One of the reasons for this improvement in the photoelectric conversion efficiency is considered to be that the inclusion of an ammonium salt increases the particle diameter of the crystals of the perovskite compound in the photoelectric conversion material, thereby reducing carrier recombination. Since the inclusion of an ammonium salt extends the PL lifetime, it is considered that the inclusion of the ammonium salt increases the carrier diffusion length.

In the photoelectric conversion material of the first embodiment, the average primary particle diameter of the perovskite compound is, for example, 2 µm or more. Since the average primary particle diameter of the perovskite compound is 2 µm or more, a carrier recombination will be further reduced. Thereby, the photoelectric conversion efficiency of the photoelectric conversion material of the first embodiment will be improved further. The average primary particle diameter of the perovskite compound of the photoelectric conversion material of the first embodiment can be obtained by measuring a primary particle diameter of the perovskite compound using a SEM image, and by calculating an average value from the measured value. Here, the measured primary particle diameter is the maximum diameter of the primary particles. For example, fifty primary particles in the SEM image are chosen, in order of primary particle diameter from the largest one. The average is calculated from the fifty primary particle diameters, and the value obtained is determined as the average primary particle diameter. The average primary particle diameter of the perovskite compound may be 5 µm or more, or 10 µm or more. The average primary particle diameter of the perovskite compound is, for example, 100 µm or less.

In the photoelectric conversion material of the first embodiment, the ammonium salt may be present between the crystals of the perovskite compound. It is considered that since the ammonium salt in this state is present in the photoelectric conversion material, a carrier path is formed between the crystals of the perovskite compound, thereby further suppressing carrier recombination. Therefore, with this configuration, the photoelectric conversion efficiency of the photoelectric conversion material of the first embodiment can be further improved.

A **PL** peak energy of the photoelectric conversion material in the first embodiment may be substantially the same as a **PL** peak energy of the perovskite compound included in the photoelectric conversion material. That is, the band gap of the photoelectric conversion material of the first embodiment may be substantially the same as the band gap of the perovskite compound included in the photoelectric conversion material. In other words, the photoelectric conversion material of the first embodiment has a crystal structure that will not change depending on the presence or absence of an ammonium salt, and the crystal structure of the perovskite compound free of an ammonium salt can be maintained. As a result, the photoelectric conversion material of the first embodiment can further improve the photoelectric conversion efficiency without changing its light absorption property (for example, the wavelength of the light to be absorbed). Saying that "PL peak energy is substantially the same" means that the difference in the **PL** peak energies is within the range from 0 eV to 0.03 eV. Further, the expression "band gap is substantially the same" means that the difference in the band gaps is within the range from 0 eV to 0.03 eV.

The **PL** peak energy of the photoelectric conversion material of the first embodiment may be, for example, less than 1.55 eV. That is, the wavelength of the PL peak of the photoelectric conversion material of the first embodiment may be more than 800 nm. The photoelectric conversion material of the first embodiment, having the PL peak, is capable of further improving the photoelectric conversion efficiency. The PL peak energy of the photoelectric conversion material of the first embodiment may be, for example, 1.1 eV or more. That is, the wavelength of the **PL** peak of the photoelectric conversion material of the first embodiment may be 1127 nm or less.

For improving the photoelectric conversion efficiency of the photoelectric conversion material, the ammonium salt may include at least one selected from the group consisting of an alkyl group and an aryl group. The number of carbon atoms in the alkyl group may be 1 or more and 10 or less. The number of carbon atoms in the alkyl group may be 1 and 7 or less.

For improving the photoelectric conversion efficiency of the photoelectric conversion material, the ammonium salt may include an alkyl group, and the number of carbon atoms in the alkyl group may be 1 or more and 10 or less. The number of carbon atoms in the alkyl group may be 1 or more and 7 or less.

For improving the photoelectric conversion efficiency of the photoelectric conversion material, the ammonium salt may include a quaternary ammonium salt. The ammonium salt may include a quaternary ammonium salt and an ammonium salt other than a quaternary ammonium salt. For further improving the photoelectric conversion efficiency of the photoelectric conversion material, the ammonium salt may be a quaternary ammonium salt.

For improving the photoelectric conversion efficiency of the photoelectric conversion material, the ammonium salt may include a halogen element. The halogen element is, for example, fluorine, chlorine, bromine, or iodine.

For improving the photoelectric conversion efficiency of the photoelectric conversion material, the ammonium salt may include an iodine-containing ammonium salt. The iodine-containing ammonium salt may be at least one selected from the group consisting of tetrapropylammonium iodide, tetrabutylammonium iodide, tetraamylammonium iodide, tetrahexylammonium iodide, and tetraheptylammonium iodide.

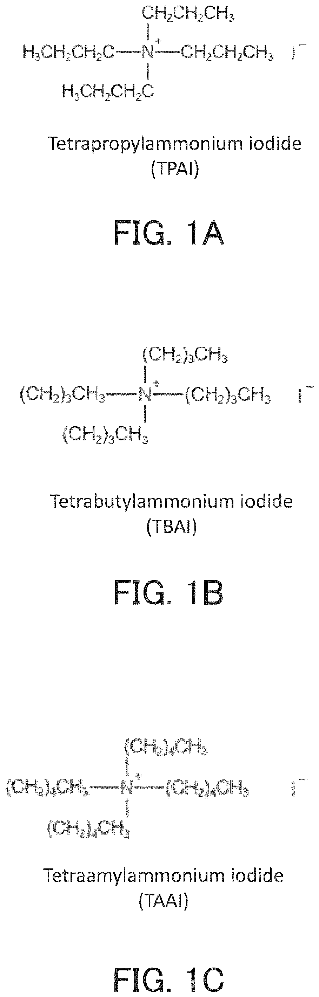

In the case where a quaternary ammonium salt containing iodine is used as the iodine-containing ammonium salt, for further improving the photoelectric conversion efficiency of the photoelectric conversion material, the iodine-containing ammonium salt may be at least one selected from the group consisting of tetrapropylammonium iodide, tetrabutylammonium iodide, and tetraamylammonium iodide. FIG. 1A shows a molecular structure of tetrapropylammonium iodide as an example of quaternary ammonium salt that may be used as the ammonium salt in the photoelectric conversion material of the first embodiment. FIG. 1B shows a molecular structure of tetrabutylammonium iodide as another example of quaternary ammonium salt that may be used as the ammonium salt in the photoelectric conversion material of the first embodiment. FIG. 1C shows a molecular structure of tetraamylammonium iodide as still another example of quaternary ammonium salt that may be used as the ammonium salt in the photoelectric conversion material of the first embodiment. Hereinafter, the tetrapropylammonium iodide is described as "TPAI", the tetrabutylammonium iodide is described as "TBAI", and the tetraamylammonium iodide is described as "TAAI".

For improving the photoelectric conversion efficiency of the photoelectric conversion material, the ammonium salt may include a fluorine-containing ammonium salt. The fluorine-containing ammonium salt may be at least one selected from the group consisting of tetramethylammonium fluoride and tetrabutylammonium fluoride. Hereafter, tetramethylammonium fluoride will be abbreviated as "TMAF".

For improving the photoelectric conversion efficiency of the photoelectric conversion material, in the photoelectric conversion material of the first embodiment, the molar ratio of the ammonium salt to the perovskite compound may be 0.01 or more and 0.50 or less.

For further improving the photoelectric conversion efficiency of the photoelectric conversion material, the molar ratio of the ammonium salt to the perovskite compound may be 0.01 or more and 0.20 or less.

For further improving the photoelectric conversion efficiency of the photoelectric conversion material, the molar ratio of the ammonium salt to the perovskite compound may be 0.05 or more and 0.10 or less.

The molar ratio of the ammonium salt to the perovskite compound may be defined by any combination selected from the numerical values of 0.01, 0.05, 0.07, 0.1, 0.15, 0.2, and 0.5.

The perovskite compound has a high light absorption coefficient in the wavelength range of the sunlight spectrum and high carrier mobility. Therefore, a photoelectric conversion material including the perovskite compound has high photoelectric conversion efficiency.

The perovskite compound may include a halogen anion. Namely, the perovskite compound may be a halide.

The perovskite compound may be made of a monovalent cation, a divalent cation, and a halogen anion. Here, the divalent cation may include at least one selected from the group consisting of a Sn cation, a Ge cation, and a Pb cation.

The monovalent cation in the perovskite compound may include an inorganic cation at a concentration of 50 mol% or more.

The perovskite compound is, for example, represented by a composition formula ABX₃. Here, A is a monovalent cation, B is a divalent metal cation, and X is a monovalent anion.

Examples of the monovalent cation A include an organic cation and an alkali metal cation. As mentioned above, the monovalent cation A may include an inorganic cation, namely, an alkali metal cation, at a concentration of 50 mol% or more.

Examples of the organic cation include a methylammonium cation (CH₃NH₃⁺), a formamidinium cation (NH₂CHNH₂⁺), and a guanidinium ion (C(NH₂)₃⁺).

Examples of the alkali metal cation include a Cs cation and a Rb cation.

The B is a divalent metal cation. Examples of the divalent cation B include a Pb cation, a Sn cation, and a Ge cation.

The X is a monovalent anion. An example of the anion X is a halogen anion. The halogen anion is, for example, chlorine, bromine, or iodine.

The sites of the cation A, the cation B, and the anion X may each include plural kinds of ions.

The perovskite compound may be at least one selected from the group consisting of CsSnI₃, CsGeI₃, and CsPbI₃.

The photoelectric conversion material of the first embodiment may further include SnF₂. In the case where the perovskite compound includes a Sn cation as a divalent cation, a Sn defect can be reduced due to the SnF₂ further included in the perovskite compound. Therefore, since the photoelectric conversion material of the first embodiment includes further SnF₂, the photoelectric conversion efficiency can be improved.

The photoelectric conversion material of the first embodiment can be manufactured, for example, by the following method.

First, a precursor solution of photoelectric conversion material of the first embodiment is prepared. The precursor solution of photoelectric conversion material of the first embodiment can be prepared, for example, by mixing a precursor solution of a perovskite compound with a solution in which an ammonium salt is dissolved. Raw materials to be used for preparing the precursor solution of photoelectric conversion material of the first embodiment include, for example, a compound including a monovalent cation such as CsI and a halogen anion, a compound including a divalent cation such as SnI₂ and a halogen anion, and a compound including a divalent cation such as SnF₂ and a F anion. One kind of solvent may be used as the solvent, or a solvent mixture including a plurality of solvents may be used. The solvent may be a solvent mixture including, for example, DMF (dimethylformamide) and DMSO (dimethyl sulfoxide).

The precursor solution of the photoelectric conversion material of the first embodiment may be prepared by, for example, first preparing a first solution, a second solution, and a third solution, and then, by mixing the second solution and the third solution with the first solution. Here, the first solution includes: a compound including a monovalent cation and a halogen anion; a compound including a divalent cation and a halogen anion; and a solvent. The second solution includes: a compound including a divalent halogen and a F anion; and a solvent. And the third solution includes an ammonium salt and a solvent.

Next, the prepared precursor solution of the photoelectric conversion material of the first embodiment is applied to a base, for example, by a coating technique such as spin coating, and the resulting coating film is left to stand for a given period of time for growth of a crystal nucleus in the coating film. Later, the coating film obtained by the spin coating is baked. For example, in the case of using a solvent mixture of DMF and DMSO (at a volume ratio of 1:1), the crystal nuclei may be allowed to grow within the coating film at room temperature and then the coating film may be baked at a temperature around 200°C, for example.

### (Second embodiment)

Hereinafter, a photoelectric conversion element of a second embodiment will be described. Matters explained in the first embodiment may be omitted as appropriate.

The photoelectric conversion element according to the second embodiment includes a first electrode, a photoelectric conversion layer, and a second electrode. The photoelectric conversion element according to the second embodiment may include the first electrode, the photoelectric conversion layer, and the second electrode in this order. The photoelectric conversion layer includes the photoelectric conversion material of the first embodiment. Therefore, the photoelectric conversion element of the second embodiment has high photoelectric conversion efficiency.

The photoelectric conversion element is, for example, a solar cell.

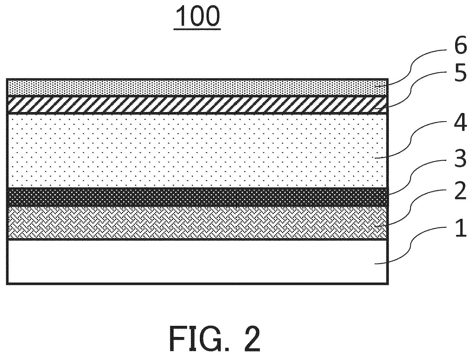

FIG. 2 is a cross-sectional view showing a schematic configuration of the photoelectric conversion element 100 of the second embodiment.

The photoelectric conversion element 100 includes a substrate 1, a first electrode 2, an electron transport layer 3, a photoelectric conversion layer 4, a hole transport layer 5, and a second electrode 6 in this order. Note that the substrate 1, the electron transport layer 3, and hole transport layer 5 may be omitted.

The photoelectric conversion layer 4 includes the photoelectric conversion material of the first embodiment. For example, the photoelectric conversion layer 4 may be a single layer, and the single layer may be made of the photoelectric conversion material of the first embodiment.

When light is irradiated onto the element 100, the photoelectric conversion layer 4 absorbs the light and separates the charges into electrons and holes. Electrons generated by this charge separation move through the electron transport layer 3 to the first electrode 2. Meanwhile, holes generated in the photoelectric conversion layer 4 move to the second electrode 6 via the hole transport layer 5. Thereby, the photoelectric conversion element 100 is capable of extracting a current from the first electrode 2 as a negative electrode and from the second electrode 6 as a positive electrode.

Hereinafter, every component of the photoelectric conversion element 100 will be explained specifically.

### (Substrate 1)

The substrate 1 supports the layers in the photoelectric conversion element 100. The substrate 1 can be formed using a transparent material. A glass substrate or a plastic substrate, for example, can be used as the substrate 1. The plastic substrate may be, for example, a plastic film.

In the case where the second electrode 6 has a light-transmitting property, the substrate 1 may be made of a material not having a light-transmitting property. As the material can be used a metal, a ceramic, or a resin material having a low light-transmitting property.

In the case where the first electrode 2 is strong enough to support the layers, the substrate 1 may be omitted.

### (First electrode 2)

The first electrode 2 has electrical conductivity.

The first electrode 2 may have a light-transmitting property. For example, the first electrode 2 allows visible to near-infrared light to pass therethrough.

The first electrode 2 may be formed of, for example, a material being transparent and having electrical conductivity. Examples of the material include metal oxides and metal nitrides. Examples of the materials include the following:
(i) titanium oxide doped with at least one selected from the group consisting of lithium, magnesium, niobium, and fluorine;
(ii) gallium oxide doped with at least one selected from the group consisting of tin and silicon;
(iii) gallium nitride doped with at least one selected from the group consisting of silicon and oxygen;
(iv) tin oxide doped with at least one selected from the group consisting of antimony and fluorine;
(v) zinc oxide doped with at least one selected from the group consisting of boron, aluminum, gallium, and indium;
(vi) indium-tin composite oxide; and
(vii) composites thereof.

The first electrode 2 may be formed to have a pattern that allows light to pass therethrough. The pattern that allows light to pass through is, for example, a linear pattern, a wave line pattern, a lattice pattern, or a perforated-metal-like pattern where a lot of small through holes are regularly or irregularly arranged. When the first electrode 2 has any of these patterns, light can pass through portions without the electrode material. Therefore, it is possible to use non-transparent materials by providing a pattern through which light can pass. Examples of the non-transparent electrode material include platinum, gold, silver, copper, aluminum, rhodium, indium, titanium, iron, nickel, tin, zinc, and an alloy including any of these elements. Alternatively, an electrically conductive carbon material can be used as the non-transparent material.

The light-transmitting property of the first electrode 2 is not necessarily achieved by the above-described pattern that allows light to pass therethrough. For example, the first electrode 2 may be formed as a thin metal film having a thickness of approximately 10 nm. The thin metal film is made of, for example, platinum, gold, silver, copper, aluminum, rhodium, indium, titanium, iron, nickel, tin, zinc, or an alloy including any of these elements. An electrically conductive carbon material may be used in place of these metal materials.

In the case where the photoelectric conversion element 100 does not include the electron transport layer 3, the first electrode 2 has a property of blocking holes from the photoelectric conversion layer 4. In this case, the first electrode 2 is not in ohmic contact with the photoelectric conversion layer 4. The property of blocking holes from the photoelectric conversion layer 4 is a property of allowing only electrons formed in the photoelectric conversion layer 4 to pass and not allowing holes to pass. The Fermi energy of a material having such a property is higher than the energy of the photoelectric conversion layer 4 at an upper part of the valence band. The Fermi energy of a material having such a property may be higher than the Fermi energy of the photoelectric conversion layer 4. The material is specifically aluminum.

In the case where the photoelectric conversion element 100 includes the electron transport layer 3, the first electrode 2 does not necessarily have the property of blocking holes from the photoelectric conversion layer 4. In this case, the first electrode 2 can include a material capable of forming an ohmic contact with the photoelectric conversion layer 4. In this case, the first electrode 2 may be in ohmic contact with the photoelectric conversion layer 4, or is not necessarily in ohmic contact with the photoelectric conversion layer 4.

The transmittance of the first electrode 2 may be, for example, 50% or more, or 80% or more. The wavelength of light that is to pass through the first electrode 2 depends on the absorption wavelength of the photoelectric conversion layer 4.

The thickness of the first electrode 2 may be, for example, 1 nm or more and 1000 nm or less.

### (Electron transport layer 3)

The electron transport layer 3 includes an electron transport material. The electron transport material may be a semiconductor. The electron transport layer 3 may be made of a semiconductor having a band gap of 3.0 eV or more. In this case, visible light and infrared light are allowed to pass therethrough to the photoelectric conversion layer 4.

The semiconductor is, for example, an inorganic n-type semiconductor.

Examples of the inorganic n-type semiconductor include a metal oxide, a metal nitride, and a perovskite oxide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. The metal oxide is, for example, TiO₂ or SnO₂. The metal nitride is, for example, GaN. The perovskite oxide is, for example, SrTiO₃ or CaTiO₃.

The electron transport layer 3 may include a semiconductor having a band gap of 6.0 eV or more to effectively allow ultraviolet to pass therethrough to the photoelectric conversion layer 4. Examples of the semiconductor include halides, such as lithium fluoride and calcium fluoride, of alkali metals and alkaline earth metals, alkali metal oxides such as magnesium oxide, and silicon dioxide. In this case, the electron transport layer 3 may have a thickness of, for example, 10 nm or less to secure the electron transport capability of the electron transport layer 3.

The electron transport layer 3 may include a plurality of layers made of different materials.

### (Photoelectric conversion layer 4)

As described above, the photoelectric conversion layer 4 includes the photoelectric conversion material of the first embodiment. The photoelectric conversion layer 4 may be a single layer, and the single layer may be made of the photoelectric conversion material of the first embodiment.

As mentioned in the first embodiment, the photoelectric conversion material of the first embodiment may be a mixture of a perovskite compound and an ammonium salt, where the perovskite compound and the ammonium salt may be mixed entirely uniformly. Therefore, the photoelectric conversion layer 4 made of the photoelectric conversion material may have a composition uniform in the thickness direction, or it may have an entirely uniform composition.

The photoelectric conversion layer 4 may include the photoelectric conversion material of the first embodiment as its main component. Saying that "the photoelectric conversion layer 4 includes the photoelectric conversion material of the first embodiment as its main component" means that the photoelectric conversion material of the first embodiment accounts for 50 mass% or more of the photoelectric conversion layer 4. The photoelectric conversion material of the first embodiment may account for 70 mass% or more of the photoelectric conversion layer 4. The photoelectric conversion material of the first embodiment may account for 90 mass% or more of the photoelectric conversion layer 4. The photoelectric conversion layer 4 may consist of the photoelectric conversion material of the first embodiment. The photoelectric conversion layer 4 needs to include the photoelectric conversion material of the first embodiment, and may include a defect or an impurity.

The photoelectric conversion layer 4 may further include a photoelectric conversion material different from the photoelectric conversion material of the first embodiment.

The thickness of the photoelectric conversion layer 4 is, for example, 50 nm or more and 10 µm or less.

The photoelectric conversion layer 4 can be formed by a coating technique involving a solution, a printing technique, or a deposition technique. Examples of the coating technique include doctor blade coating, bar coating, spraying, dip coating, inkjet coating, slit coating (namely, die coating), and spin coating.

### (Hole transport layer 5)

The hole transport layer 5 includes a hole transport material. The hole transport material is a material that transports a hole. The hole transport material is, for example, an organic semiconductor or an inorganic semiconductor.

Examples of the organic semiconductor include triphenylamine, triallylamine, phenylbenzidine, phenylenevinylene, tetrathiafulvalene, vinyl naphthalene, vinylcarbazole, thiophene, aniline, pyrrole, carbazole, triptycene, fluorene, azulene, pyrene, pentacene, perylene, acridine, and phthalocyanine.

Typical examples of the organic semiconductor used as the hole transport material include 2,2',7,7'-tetrakis-(N,N-di-p-methoxyphenylamine)9,9'-spirobifluorene, poly[bis(4-phenyl)(2,4,6-trimethylphenyl)amine] (which may be referred to as "PTAA" hereinafter), poly(3-hexylthiophene-2,5-diyl), poly(3,4-ethylenedioxythiophene), and copper phthalocyanine.

The inorganic semiconductor used as the hole transport material is a p-type semiconductor. Examples of the inorganic semiconductor include Cu₂O, CuGaO₂, CuSCN, Cul, NiOₓ, MoOₓ, V₂O₅, and a carbon material such as graphene oxide. Here, x satisfies x > 0.

The hole transport layer 5 may include a plurality of layers made of different materials. For example, hole transport properties of the hole transport layer 5 are improved by stacking the plurality of layers whose ionization potentials are smaller than that of the photoelectric conversion layer 4 such that the ionization potentials decrease layer by layer.

The thickness of the hole transport layer 5 may be 1 nm or more and 1000 nm or less, or 10 nm or more and 50 nm or less. This allows the hole transport layer 5 to exhibit sufficiently high hole transport properties. Consequently, the resistance of the photoelectric conversion element 100 can be maintained at a low level, and a high photoelectric conversion efficiency can be achieved.

The hole transport layer 5 is formed, for example, by a coating technique, a printing technique, or a deposition technique. The same can be said to the photoelectric conversion layer 4. Examples of the coating technique include doctor blade coating, bar coating, spraying, dip coating, inkjet coating, slit coating (namely, die coating), and spin coating. Examples of the printing technique include screen printing. If needed, the hole transport layer 5 may be formed using a mixture of a plurality of materials and then, for example, compressed or baked. In the case that the material of the hole transport layer 5 is a low-molecular-weight organic substance or an inorganic semiconductor, the hole transport layer 5 can be produced by vacuum deposition.

The hole transport layer 5 may include not only the hole transport material but an additive to increase the electrical conductivity. Examples of the additive include a supporting electrolyte, a solvent, and a dopant. The supporting electrolyte and the solvent stabilize holes in the hole transport layer 5. The dopant increases the number of holes in the hole transport layer 5.

Examples of the supporting electrolyte include an ammonium salt, an alkaline earth metal salt, and a transition metal salt. Examples of the ammonium salt include tetrabutylammonium perchlorate, tetraethylammonium hexafluorophosphate, an imidazolium salt, and a pyridinium salt. Examples of the alkali metal salt include lithium perchlorate and potassium tetrafluoroborate. Examples of the alkaline earth metal salt include lithium bis(trifluoromethanesulfonyl)imide and calcium(II) bis(trifluoromethanesulfonyl)imide. Examples of the transition metal salt include zinc(II) bis(trifluoromethanesulfonyl)imide and tris[4-tert-butyl-2-(1H-pyrazole-1-yl)pyridine]cobalt(III) tris(trifluoromethanesulfonyl)imide.

Examples of the dopant include a fluorine-containing aromatic boron compound. Examples of the fluorine-containing aromatic boron compound include tris(pentafluorophenyl)borane.

The solvent included in the hole transport layer 5 may have excellent ion conductivity. The solvent may be an aqueous solvent or an organic solvent. To make the solute more stable, the solvent included in the hole transport layer 5 may be an organic solvent. Examples of the organic solvent include heterocyclic compound solvents such as tert-butylpyridine, pyridine, and n-methylpyrrolidone.

An ionic liquid may be used as the solvent. The ionic liquid may be used alone, or may be used after mixed with a different solvent. The ionic liquid is desirable for its low volatility and high flame retardancy.

Examples of the ionic liquid include imidazolium ionic liquids such as 1-ethyl-3-methylimidazolium tetracyano borate, pyridine ionic liquids, alicyclic amine ionic liquids, aliphatic amine ionic liquids, and azonium amine ionic liquids.

### (Second electrode 6)

The second electrode 6 has electrical conductivity.

In the case where the photoelectric conversion element 100 does not include the hole transport layer 5, the second electrode 6 has a property of blocking electrons from the photoelectric conversion layer 4. In this case, the second electrode 6 is not in ohmic contact with the photoelectric conversion layer 4. The property of blocking electrons from the photoelectric conversion layer 4 refers to a property of allowing only holes formed in the photoelectric conversion layer 4 to pass and not allowing electrons to pass. The Fermi energy of a material having such a property is lower than the energy of the photoelectric conversion layer 4 at a lower part of the conduction band. The Fermi energy of a material having such a property may be lower than the Fermi energy of the photoelectric conversion layer 4. The material is specifically platinum, gold, or a carbon material such as graphene.

In the case where the photoelectric conversion element 100 includes the hole transport layer 5, the second electrode 6 does not necessarily have the property of blocking electrons from the photoelectric conversion layer 4. In this case, the second electrode 6 can include a material capable of forming an ohmic contact with the photoelectric conversion layer 4. Therefore, the second electrode 6 can be formed to have a light-transmitting property.

An electrode that is the first electrode 2 or the second electrode 6 and that is configured to allow light to be incident thereon needs to have a light-transmitting property. That is, either the first electrode 2 or the second electrode 6 does not necessarily have a light-transmitting property. In other words, either the first electrode 2 or the second electrode 6 does not necessarily include a material having a light-transmitting property, or does not necessarily have a pattern including an opening portion that allows light to pass therethrough.

### (Porous layer)

A porous layer is formed on the electron transport layer 3, for example, by a coating technique. In the case that the photoelectric conversion element 100 does not include the electron transport layer 3, the porous layer is formed on the first electrode 2.

A pore structure provided by the porous layer serves as a foundation at the time of formation of the photoelectric conversion layer 4. The porous layer does not prevent light absorption by the photoelectric conversion layer 4 and electron transfer from the photoelectric conversion layer 4 to the electron transport layer 3.

The porous layer includes a porous body.

The porous body is made of, for example, continuous insulating particles or continuous semiconductor particles. The insulating particles are, for example, aluminum oxide particles or silicon oxide particles. The semiconductor particles are, for example, inorganic semiconductor particles. The inorganic semiconductor is, for example, a metal oxide, a perovskite oxide of a metal element, a sulfide of a metal element, or a metal chalcogenide. The metal oxide is, for example, an oxide of Cd, Zn, In, Pb, Mo, W, Sb, Bi, Cu, Hg, Ti, Ag, Mn, Fe, V, Sn, Zr, Sr, Ga, Si, or Cr. The metal oxide is, for example, TiO₂. The perovskite oxide of a metal element is, for example, SrTiO₃ or CaTiOs. The sulfide of a metal element is, for example, CdS, ZnS, In₂S₃, PbS, Mo₂S, WS₂, Sb₂S₃, Bi₂S₃, ZnCdS₂, or Cu₂S. The metal chalcogenide is, for example, CsSe, In₂Se₃, WSe₂, HgS, PbSe, or CdTe.

The thickness of the porous layer may be 0.01 µm or more and 10 µm or less, or 0.05 µm or more and 1 µm or less.

Regarding surface roughness of the porous layer, a surface roughness factor determined by "effective area/projected area" may be 10 or greater, or 100 or greater. The projected area refers to the area of a shadow behind an object irradiated with light from the front. The effective area refers to the actual surface area of an object. The effective area can be calculated from a volume of an object, the specific surface area of the material of the object, and the bulk density of the material of the object, the volume being determined from the projected area and the thickness of the object. The specific surface area is measured, for example, by a nitrogen adsorption method.

A void in the porous layer is continuous from one principal surface of the porous layer to the other principal surface. That is, a void in the porous layer is continuous from a principal surface of the porous layer in contact with the photoelectric conversion layer 4 to a principal surface of the porous layer in contact with the electron transport layer 3. This allows the material of the photoelectric conversion layer 4 to fill the void of the porous layer and reach the surface of the electron transport layer 3. The photoelectric conversion layer 4 and the electron transport layer 3 are thus in direct contact to each other and therefore can give and receive electrons therebetween.

Inclusion of the porous layer makes it easy to form the photoelectric conversion layer 4. When the porous layer is included, the material of the photoelectric conversion layer 4 enters the void of the porous layer and the porous layer serves as a foothold for the photoelectric conversion layer 4. This makes it unlikely that the material of the photoelectric conversion layer 4 is repelled by the surface of the porous layer or aggregates on the surface of the porous layer. Consequently, the photoelectric conversion layer 4 can be easily formed as a uniform film. The photoelectric conversion layer 4 can be formed by the above coating technique or the like.

The porous layer can increase the optical path length of light passing through the photoelectric conversion layer 4 by causing light scattering. The amount of electrons and holes formed in the photoelectric conversion layer 4 is expected to increase with the increase of the optical path length.

### [Other embodiments]

### (Supplement)

According to the description of the above embodiments, the following techniques are disclosed.

### (Technique 1)

A photoelectric conversion material including a perovskite compound and an ammonium salt.

The photoelectric conversion material of the technique 1 configured as above can improve the photoelectric conversion efficiency of the photoelectric conversion material.

### (Technique 2)

The photoelectric conversion material according to the technique 1, wherein
the photoelectric conversion material has a photoluminescence peak energy of less than 1.55 eV.

The photoelectric conversion material of the technique 2 configured as above can further improve the photoelectric conversion efficiency of the photoelectric conversion material.

### (Technique 3)

The photoelectric conversion material according to the technique 1 or 2, wherein
the perovskite compound has an average primary particle diameter of 2 µm or more.

The photoelectric conversion material of the technique 3 configured as above can further improve the photoelectric conversion efficiency of the photoelectric conversion material.

### (Technique 4)

The photoelectric conversion material according to any one of the techniques 1 to 3, wherein
a photoluminescence peak energy of the photoelectric conversion material is substantially the same as a photoluminescence peak energy of the perovskite compound.

The photoelectric conversion material of the technique 4 configured as above can further improve the photoelectric conversion efficiency of the photoelectric conversion material without changing the light absorption property (e.g., wavelength of light to be absorbed).

### (Technique 5)

The photoelectric conversion material according to any one of the techniques 1 to 4, wherein
the ammonium salt includes at least one selected from the group consisting of an alkyl group and an aryl group.

The photoelectric conversion material of the technique 5 configured as above can further improve the photoelectric conversion efficiency of the photoelectric conversion material.

### (Technique 6)

The photoelectric conversion material according to the technique 5, wherein
the ammonium salt includes the alkyl group, and
the alkyl group has 1 or more and 10 carbon atoms.

The photoelectric conversion material of the technique 6 configured as above can further improve the photoelectric conversion efficiency of the photoelectric conversion material.

### (Technique 7)

The photoelectric conversion material according to any one of the techniques 1 to 6, wherein
the ammonium salt includes a quaternary ammonium salt.

The photoelectric conversion material of the technique 7 configured as above can further improve the photoelectric conversion efficiency of the photoelectric conversion material.

### (Technique 8)

The photoelectric conversion material according to any one of the techniques 1 to 7, wherein
the ammonium salt includes a halogen element.

The photoelectric conversion material of the technique 8 configured as above can further improve the photoelectric conversion efficiency of the photoelectric conversion material.

### (Technique 9)

The photoelectric conversion material according to the technique 8, wherein
the ammonium salt includes an iodine-containing ammonium salt.

The photoelectric conversion material of the technique 9 configured as above can further improve the photoelectric conversion efficiency of the photoelectric conversion material.

### (Technique 10)

The photoelectric conversion material according to the technique 9, wherein
the iodine-containing ammonium salt is at least one selected from the group consisting of tetrapropylammonium iodide, tetrabutylammonium iodide, tetraamylammonium iodide, tetrahexylammonium iodide, and tetraheptylammonium iodide.

The photoelectric conversion material of the technique 10 configured as above can further improve the photoelectric conversion efficiency of the photoelectric conversion material.

### (Technique 11)

The photoelectric conversion material according to any one of the techniques 8 to 10, wherein
the ammonium salt includes a fluorine-containing ammonium salt.

The photoelectric conversion material of the technique 11 configured as above can further improve the photoelectric conversion efficiency of the photoelectric conversion material.

### (Technique 12)

The photoelectric conversion material according to the technique 11, wherein
the fluorine-containing ammonium salt is at least one selected from the group consisting of tetramethylammonium fluoride and tetrabutylammonium fluoride.

The photoelectric conversion material of the technique 12 configured as above can further improve the photoelectric conversion efficiency of the photoelectric conversion material.

### (Technique 13)

The photoelectric conversion material according to any one of the techniques 1 to 12, wherein
a molar ratio of the ammonium salt to the perovskite compound is 0.01 or more and 0.50 or less.

The photoelectric conversion material of the technique 13 configured as above can further improve the photoelectric conversion efficiency of the photoelectric conversion material.

### (Technique 14)

The photoelectric conversion material according to the technique 13, wherein
the molar ratio is 0.05 or more and 0.10 or less.

The photoelectric conversion material of the technique 14 configured as above can further improve the photoelectric conversion efficiency of the photoelectric conversion material.

### (Technique 15)

The photoelectric conversion material according to any one of the techniques 1 to 14, wherein
the perovskite compound includes a halogen anion.

The photoelectric conversion material of the technique 15 configured as above can further improve the photoelectric conversion efficiency of the photoelectric conversion material.

### (Technique 16)

The photoelectric conversion material according to any one of the techniques 1 to 15, wherein
the perovskite compound is made of a monovalent cation, a divalent cation, and a halogen anion, and
the divalent cation includes at least one selected from the group consisting of a Sn cation, a Ge cation and a Pb cation.

The photoelectric conversion material of the technique 16 configured as above can further improve the photoelectric conversion efficiency of the photoelectric conversion material.

### (Technique 17)

The photoelectric conversion material according to the technique 16, wherein
the monovalent cation includes an inorganic cation at a concentration of 50 mol% or more.

The photoelectric conversion material of the technique 17 configured as above can further improve the photoelectric conversion efficiency of the photoelectric conversion material.

### (Technique 18)

The photoelectric conversion material according to the technique 16 or 17, wherein
the perovskite compound is at least one selected from the group consisting of CsSnls, CsGeI₃, and CsPbI₃.

The photoelectric conversion material of the technique 18 configured as above can further improve the photoelectric conversion efficiency of the photoelectric conversion material.

### (Technique 19)

The photoelectric conversion material according to any one of the techniques 1 to 18, further including SnF₂.

The photoelectric conversion material of the technique 19 configured as above can further improve the photoelectric conversion efficiency of the photoelectric conversion material.

### (Technique 20)

A photoelectric conversion element including:
a first electrode;
a photoelectric conversion layer; and
a second electrode, wherein
the photoelectric conversion layer includes the photoelectric conversion material according to any one of the techniques 1 to 19.

The photoelectric conversion element of the technique 20 configured as above can have a high photoelectric conversion efficiency.

### EXAMPLES

The present disclosure will be described hereinafter in more details with reference to Examples and Comparative Examples.

The preparation of the raw material solutions of the photoelectric conversion layer and the hole transport layer, and the formation of the photoelectric conversion layer and the hole transport layer were carried out in a glove box in which the oxygen concentration and the moisture concentration were each 1 ppm or lower.

### <Production of photoelectric conversion element>

### (Example 1)

First, a glass substrate was prepared. The substrate plays the role of a supporting material for the photoelectric conversion element of the present disclosure.

An indium tin oxide (ITO) layer was formed on the substrate by sputtering. Furthermore, an antimony tin oxide (ATO) layer was formed on the ITO layer by sputtering. A first electrode was formed in this manner.

Next, a compact titanium oxide (TiO₂) layer was formed on the ATO layer of the first electrode by sputtering. This compact titanium oxide (TiO₂) layer corresponds, for example, to the electron transport layer described in the above first embodiment.

Next, 0.45 g of a titanium oxide paste 30NR-D (manufactured by Gratcell Solar Materials Pty Ltd.) was dissolved in 2 mL of a butanol solution. The resulting solution was applied to the electron transport layer by spin coating, followed by baking at 500°C for 20 minutes. A porous titanium oxide layer was formed in this manner. The spin coating was performed at 4000 rpm for 20 seconds. It should be noted that both the above compact titanium oxide layer and the above porous titanium oxide layer have an electron transport capability. Therefore, it can be considered that an electron transport layer is composed of the above compact titanium oxide layer and the above porous titanium oxide layer.

A precursor solution of a photoelectric conversion layer was applied to the porous layer by spin coating, and then, left to stand still at room temperature for 10 minutes. After that, the coating film was baked at 200°C for 10 minutes. A photoelectric conversion layer was formed in this manner. During the film formation by spin coating at 5000 rpm for 30 seconds, chlorobenzene being a poor solvent was supplied dropwise.

The precursor solution of the photoelectric conversion layer was obtained in the following manner. First, SnI₂ and CsI were added to a solvent mixture containing DMF and DMSO (at a volume ratio of 1:1) to prepare a 0.9 mol/L first solution. Next, SnF₂ was added to a solvent mixture containing DMF and DMSO (at a volume ratio of 1:1) to prepare a 0.9 mol/L second solution. Further, TBAI was added to a solvent mixture containing DMF and DMSO (at a volume ratio of 1:1) to prepare a 0.9 mol/L third solution. The second solution and the third solution were added to the first solution. The precursor solution was obtained in this manner.

The precursor solutions, for which the concentration of the second solution added to the first solution was 16 mol% and the concentration of the third solution added to the first solution was 5 mol%, were used in Examples. In Examples 1 and 2, the photoelectric conversion layers were obtained by baking respectively at 200°C and 220°C.

Next, a raw material solution of a hole transport layer was applied to the photoelectric conversion layer by spin coating. A hole transport layer was formed in this manner. The raw material solution of the hole transport layer was prepared by dissolving 18 mg of poly[bis(4-phenyl)(2,4,6-trimethylphenyl)amine] (PTAA) in 1 mL of chlorobenzene. The spin coating was performed at 4000 rpm for 20 seconds.

Then, a gold film was formed on the hole transport layer by deposition. A second electrode having a thickness of 200 nm was obtained in this manner.

Finally, a UV-curable epoxy resin was applied to a periphery of the substrate, another glass substrate was placed thereon, and the resulting laminate was irradiated with UV. The epoxy resin was thereby cured to encapsulate the electricity generation constituents.

### (Example 2)

A photoelectric conversion element was obtained in the same manner as Example 1 except that in production of the photoelectric conversion layer, the temperature for baking the coating film made of the precursor solution of the photoelectric conversion layer was set to 220°C.

### (Example 3)

A photoelectric conversion element was obtained in the same manner as Example 1 except that in production of the photoelectric conversion layer, the third solution was added at a concentration of 7.5 mol% in preparation of the precursor solution of the photoelectric conversion layer.

### (Example 4)

A photoelectric conversion element was obtained in the same manner as Example 1 except that in production of the photoelectric conversion layer, the third solution was added at a concentration of 10 mol% in preparation of the precursor solution of the photoelectric conversion layer.

### (Example 5)

A photoelectric conversion element was obtained in the same manner as Example 1 except that in production of the photoelectric conversion layer, the third solution to be used for preparation of the precursor solution of the photoelectric conversion layer was altered and that the temperature for baking the coating film was set to 220°C. In Example 5, TPAI was added to the solvent mixture containing DMF and DMSO (at a volume ratio of 1:1) to prepare a 0.9 mol/L third solution. In preparation of the precursor solution of the photoelectric conversion layer, the concentrations of the added second solution and the added third solution were the same as those of Example 1. That is, in Example 5, the second solution was added at a concentration of 16 mol%, and the third solution was added at a concentration of 5 mol%.

### (Example 6)

A photoelectric conversion element was obtained in the same manner as Example 1 except that in production of the photoelectric conversion layer, the third solution to be used for preparation of the precursor solution of the photoelectric conversion layer was altered and that the temperature for baking the coating film was set to 220°C. In Example 6, the TAAI was added to the solvent mixture containing DMF and DMSO (at a volume ratio of 1:1) to prepare a 0.9 mol/L third solution. In the preparation of the precursor solution of the photoelectric conversion layer, the concentrations of the added second solution and the added third solution were the same as those of Example 1. That is, in Example 6, the second solution was added at a concentration of 16 mol%, and the third solution was added at a concentration of 5 mol%.

### (Example 7)

A photoelectric conversion element was obtained in the same manner as Example 1 except that the photoelectric conversion layer was produced by a different method. The method for producing the photoelectric conversion layer in Example 7 was as follows.

A precursor solution of a photoelectric conversion layer was applied to a porous layer by spin coating, and then, left to stand still at room temperature for 10 minutes. Later, the coating film was baked at 160°C for 1 minute, and further baked at 240°C for 10 minutes. A photoelectric conversion layer was formed in this manner. During the film formation by spin coating at 5000 rpm for 30 seconds, chlorobenzene being a poor solvent was supplied dropwise.

The precursor solution of the photoelectric conversion layer in Example 7 was obtained in the following manner. First, SnI₂ and CsI were added to a solvent mixture containing DMF and DMSO (DMF : DMSO = 1:4 at a volume ratio) to prepare a 1.5 mol/L first solution. Next, TMAF was added to a solvent mixture containing DMF and DMSO (DMF : DMSO = 1:4 at a volume ratio) to prepare a 1.5 mol/L third solution. The third solution was added to the first solution at a concentration of 5 mol%. A precursor solution of photoelectric conversion layer was obtained in this manner. It should be noted that unlike Example 1, the second solution was not used for the precursor solution of the photoelectric conversion layer of Example 7.

### (Example 8)

A photoelectric conversion element was obtained in the same manner as Example 7 except that in production of the photoelectric conversion layer, the third solution was added at a concentration of 10 mol% in preparation of the precursor solution of the photoelectric conversion layer.

### (Example 9)

A photoelectric conversion element was obtained in the same manner as Example 7 except that in production of the photoelectric conversion layer, the third solution was added at a concentration of 15 mol% in preparation of the precursor solution of the photoelectric conversion layer.

### (Example 10)

A photoelectric conversion element was obtained in the same manner as Example 7 except that in production of the photoelectric conversion layer, the third solution was added at a concentration of 20 mol% in preparation of the precursor solution of the photoelectric conversion layer.

### (Comparative Example 1)

A photoelectric conversion element was obtained in the same manner as Example 1 except that in production of the photoelectric conversion layer, only the second solution was added to the first solution to prepare the precursor solution of the photoelectric conversion layer while the third solution was not added.

### (Comparative Example 2)

A photoelectric conversion element was obtained in the same manner as Example 1 except that in production of the photoelectric conversion layer, only the second solution was added to the first solution to prepare the precursor solution of the photoelectric conversion layer while the third solution was not added, and that the temperature for baking the coating film was set to 220°C.

### (Comparative Example 3)

A photoelectric conversion element was obtained in the same manner as Example 1 except that in production of the photoelectric conversion layer, only the second solution was added to the first solution to prepare the precursor solution of the photoelectric conversion layer while the third solution was not added, and that the temperature for baking the coating film was set to 240°C.

### (Comparative Example 4)

A photoelectric conversion element was obtained in the same manner as Example 1 except that in production of the photoelectric conversion layer, only the second solution was added to the first solution to prepare the precursor solution of the photoelectric conversion layer while the third solution was not added, and that the temperature for baking the coating film was set to 180°C.

### (Comparative Example 5)

A photoelectric conversion element was obtained in the same manner as Example 1 except that the photoelectric conversion layer was produced by a different method. The method for producing the photoelectric conversion layer in Comparative Example 5 was as follows.

A precursor solution of a photoelectric conversion layer was applied to a porous layer by spin coating, and then, left to stand still at room temperature for 10 minutes. Later, the coating film was baked at 180°C for 10 minutes. A photoelectric conversion layer was formed in this manner. During the film formation by spin coating at 5000 rpm for 30 seconds, chlorobenzene being a poor solvent was supplied dropwise.

The precursor solution of the photoelectric conversion layer was obtained in the following manner. First, SnI₂ and CsI were added to a solvent mixture containing DMF and DMSO (at a volume ratio of 1:1) to prepare a 0.9 mol/L first solution. Next, SnF₂ was added to a solvent mixture containing DMF and DMSO (at a volume ratio of 1:1) to prepare a 0.9 mol/L second solution. The second solution was added to the first solution at a concentration of 16 mol%, so that a precursor solution of the photoelectric conversion layer was obtained. Further, for a post-processing after formation of the photoelectric conversion layer, a third solution was prepared under the conditions where the best improvement in properties in Non Patent Literature 1 was obtained. That is, 1 mg of TBAI was added to 1 mL of IPA (isopropyl alcohol) to prepare the third solution.

Subsequently, the formed photoelectric conversion layer was subjected to a post-processing under the conditions where the best improvement in properties in Non Patent Literature 1 was obtained. Specifically, a TBAI layer was formed on the photoelectric conversion layer. The TABI layer was produced by spin coating the third solution at 5000 rpm for 30 seconds, followed by baking at 100°C for 3 minutes.

### (Comparative Example 6)

A photoelectric conversion element was obtained in the same manner as Comparative Example 5 except that in production of the photoelectric conversion layer, the temperature for baking the coating film was set to 200°C. That is, in Comparative Example 6, a TBAI layer was formed on the photoelectric conversion layer in the same manner as Comparative Example 5.

### <Evaluation of characteristic of photoelectric conversion element>

Current-voltage characteristics (namely, I-V characteristics) were evaluated for the photoelectric conversion elements of Examples 1 to 10 and Comparative Examples 1 to 6.

A solar simulator (manufactured by Bunkoukeiki Co., Ltd.) and an electrochemical analyzer ALS (manufactured by BAS Inc.) were used for the evaluation of the characteristics. Each photoelectric conversion element was irradiated with one sun of simulated sunlight. The output of the solar simulator was set to 100 mW/cm². The I-V characteristics of the photoelectric conversion elements were measured by measuring output current values using the electrochemical analyzer under varying applied voltage.

Tables 1 and 2 show the measurement results. The symbol η represents the conversion efficiency. The symbol Jsc represents the short-circuit current density. The symbol V_{oc} represents the open-circuit voltage. The symbol FF represents the fill-factor. Tables 1 and 2 show also an additive (i.e., ammonium salt) to be added to the CsSnI₃ that is the perovskite compound for forming photoelectric conversion layers, and the concentrations of the additives, baking temperatures for forming the photoelectric conversion layers, and whether or not post-processing to the photoelectric conversion layer (i.e., formation of TBAI layer) was performed. In these tables, the amounts of the components actually added represent the molar ratios. The molar ratios of the ammonium salts to the perovskite compounds can be calculated from the ratios based on the amounts of the components actually added. Preliminary experiments conducted by the applicant confirmed the following fact, namely, the molar ratio of the ammonium salt to the perovskite compound, which is calculated from the ratio of the raw material actually added, is not significantly different from the molar ratio of the ammonium salt to the perovskite compound calculated using the composition ratio determined from elemental analysis of the produced photoelectric conversion layer. That is, in Example 1 for example, since the ammonium salt is added at a concentration of 5 mol%, the molar ratio of the ammonium salt to the perovskite compound in the produced photoelectric conversion layer can be estimated as 0.05.

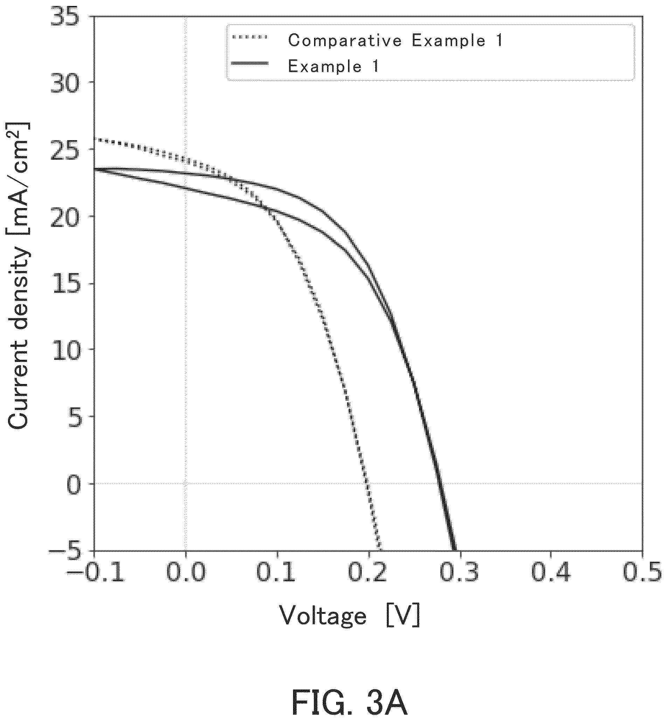

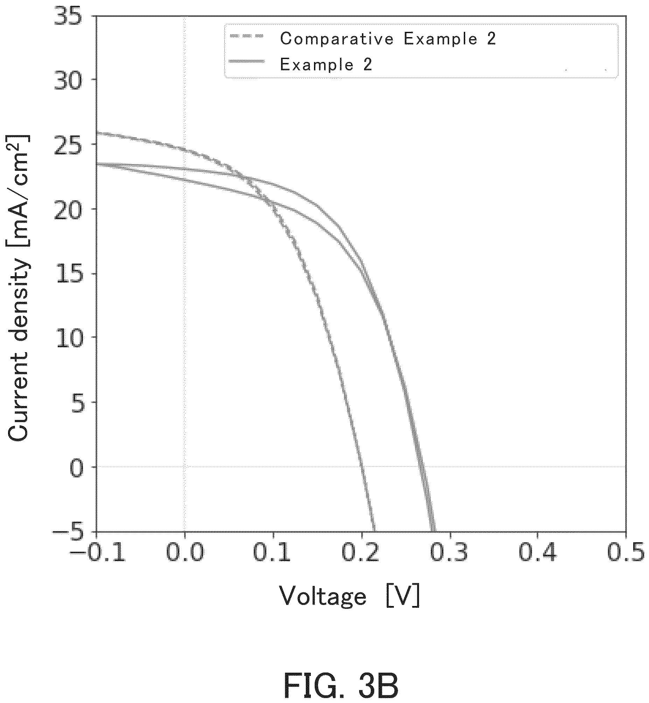

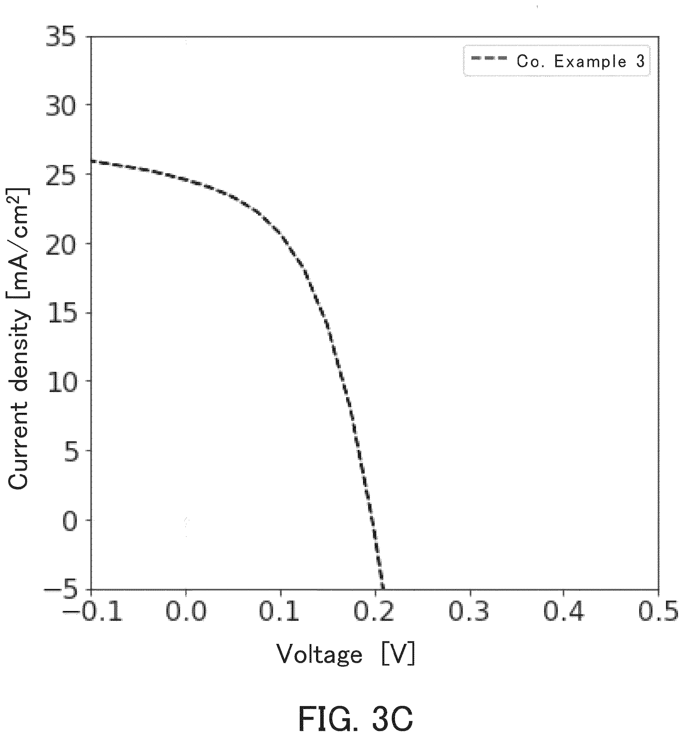

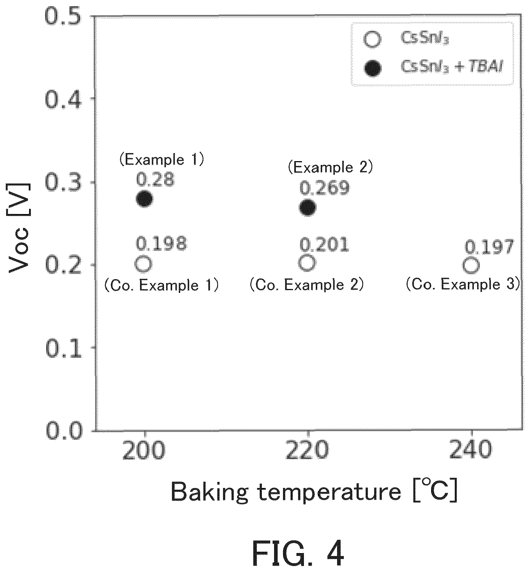

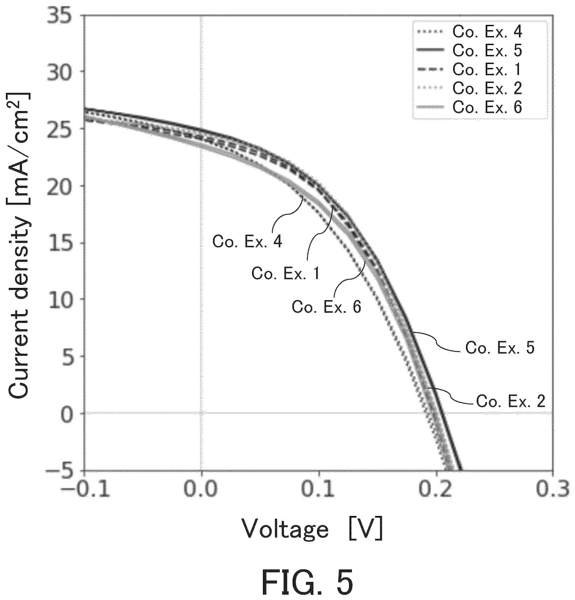

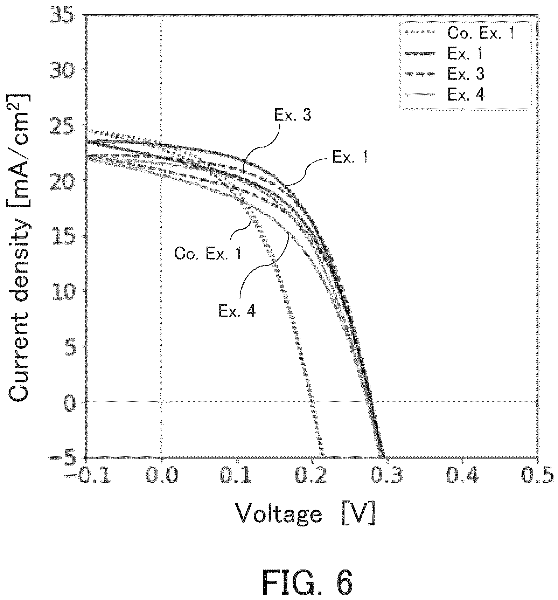

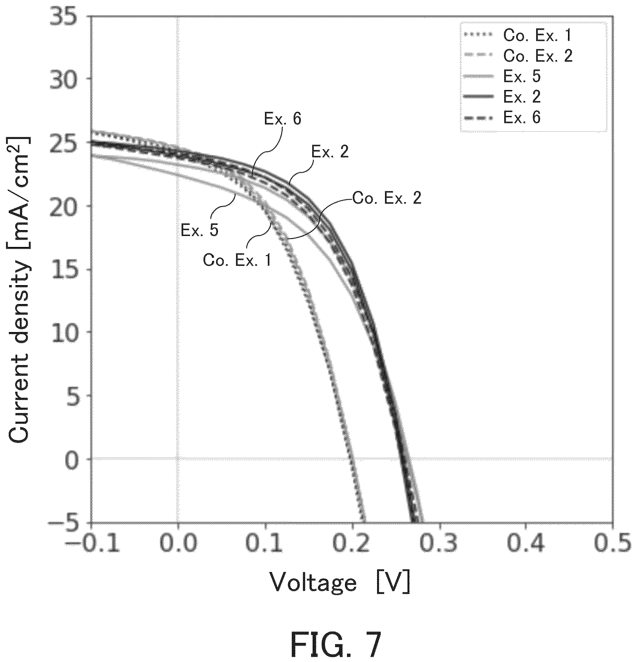

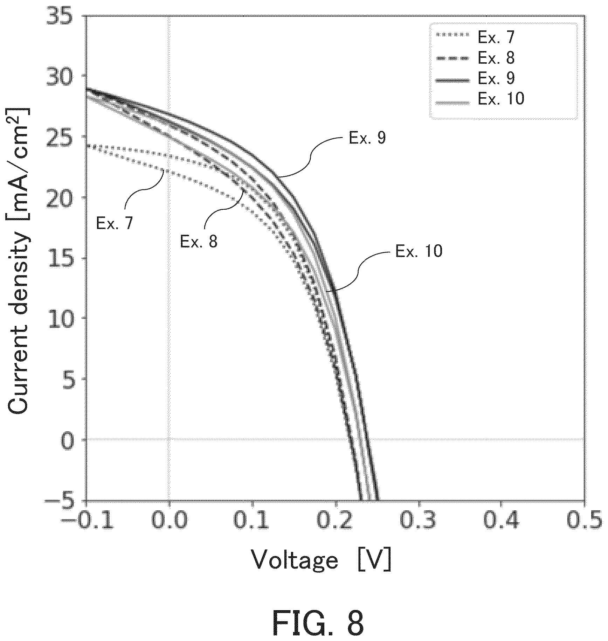

FIG. 3A is a graph showing the I-V characteristics of the photoelectric conversion elements of Example 1 and Comparative Example 1. FIG. 3B is a graph showing the I-V characteristics of the photoelectric conversion elements of Example 2 and Comparative Example 2. FIG. 3C is a graph showing the I-V characteristic of the photoelectric conversion element of Comparative Example 3. FIG. 4 is a graph showing an increase of an open-circuit voltage (Voc), which is caused by addition of tetrabutylammonium iodide to CsSnI₃. FIG. 5 is a graph showing the I-V characteristics of the photoelectric conversion elements of Comparative Examples 1, 2, and 4 to 6. FIG. 6 is a graph showing the I-V characteristics in Example 1, Example 3, Example 4, and Comparative Example 1. FIG. 7 is a graph showing the I-V characteristics in Example 2, Example 5, Example 6, Comparative Example 1, and Comparative Example 2. And FIG. 8 is a graph showing the I-V characteristics in Examples 7 to 10.

**[Table 1]**

| | Production of photoelectric conversion layer | | | |
|---|---|---|---|---|
| | Addition of ammonium salt | Concentration of added ammonium salt (mol%) | Baking temperature (°C) | Post-processing (TBAI layer formation) |
| Example 1 | Yes (TBAI) | 5 | 200 | No |
| Example 2 | Yes (TBAI) | 5 | 220 | No |
| Example 3 | Yes (TBAI) | 7.5 | 200 | No |
| Example 4 | Yes (TBAI) | 10 | 200 | No |
| Example 5 | Yes (TPAI) | 5 | 220 | No |
| Example 6 | Yes (TAAI) | 5 | 220 | No |
| Comparative Example 1 | No | 0 | 200 | No |
| Comparative Example 2 | No | 0 | 220 | No |
| Comparative Example 3 | No | 0 | 240 | No |
| Comparative Example 4 | No | 0 | 180 | No |
| Comparative Example 5 | No | 0 | 180 | Yes |
| Comparative Example 6 | No | 0 | 220 | No |

**[Table 1] (continued)**

| | Properties of photoelectric conversion element | | | |
|---|---|---|---|---|
| | η (%) | Jsc (mA/cm²) | Voc (V) | FF |
| Example 1 | 3.06 | 22.030 | 0.280 | 0.497 |
| Example 2 | 3.04 | 22.180 | 0.270 | 0.508 |
| Example 3 | 2.96 | 20.870 | 0.278 | 0.510 |
| Example 4 | 2.61 | 20.420 | 0.275 | 0.465 |
| Example 5 | 2.74 | 22.370 | 0.264 | 0.465 |
| Example 6 | 2.98 | 23.710 | 0.257 | 0.488 |
| Comparative Example 1 | 2.09 | 24.040 | 0.198 | 0.440 |
| Comparative Example 2 | 2.18 | 24.570 | 0.201 | 0.442 |
| Comparative Example 3 | 2.27 | 24.530 | 0.197 | 0.470 |
| Comparative Example 4 | 1.78 | 24.010 | 0.192 | 0.387 |
| Comparative Example 5 | 2.15 | 24.750 | 0.205 | 0.425 |
| Comparative Example 6 | 1.95 | 23.340 | 0.197 | 0.426 |

**[Table 2]**

| | Production of photoelectric conversion layer | | | |
|---|---|---|---|---|
| | Addition of ammonium salt | Concentration of added ammonium salt (mol%) | Baking condition | Post-processing (TBAI layer formation) |
| Example 7 | Yes (TMAF) | 5 | 160°C 1 min. | No |
| | | | 240°C 10min. | |
| Example 8 | Yes (TMAF) | 10 | 160°C 1 min. | No |
| | | | 240°C 10 min. | |
| Example 9 | Yes (TMAF) | 15 | 160°C 1 min. | No |
| | | | 240°C 10 min. | |
| Example 10 | Yes (TMAF) | 20 | 160°C 1 min. | No |
| | | | 240°C 10 min. | |

**[Table 2] (continued)**

| | Properties of photoelectric conversion element | | | |
|---|---|---|---|---|
| | η (%) | Jsc (mA/cm²) | Voc (V) | FF |
| Example 7 | 2.47 | 23.350 | 0.219 | 0.484 |
| Example 8 | 2.53 | 25.890 | 0.220 | 0.445 |
| Example 9 | 2.99 | 26.790 | 0.469 | 0.469 |
| Example 10 | 2.79 | 26.000 | 0.230 | 0.466 |

As shown in Tables 1 and 2, the photoelectric conversion elements of Examples 1 to 10, each of which including a photoelectric conversion layer made of a photoelectric conversion material including an ammonium salt, had a higher conversion efficiency than that of the photoelectric conversion elements of Comparative Examples 1 to 4, each of which including a photoelectric conversion layer made of a photoelectric conversion material free of an ammonium salt. Further, the photoelectric conversion elements of Examples 1 to 10 each had a higher conversion efficiency than the photoelectric conversion elements of Comparative Examples 5 and 6, each of which including a photoelectric conversion layer whose surface being subjected to a post-processing with a TBAI solution as disclosed in Non Patent Literature 1. It has been confirmed from these results that the photoelectric conversion material of the present disclosure, which includes the perovskite compound and an ammonium salt, is capable of improving its photoelectric conversion efficiency.

As shown in FIG. 3A, FIG. 3B, FIG. 3C, and FIG. 4, the photoelectric conversion elements of Examples 1 and 2 each had an open-circuit voltage significantly increased in comparison with the photoelectric conversion elements of Comparative Examples 1 to 3. As a result, the photoelectric conversion elements of Examples 1 and 2 each achieved a conversion efficiency higher by about 1% than those of the photoelectric conversion elements of Comparative Examples 1 to 3.

Comparison of Example 1, Example 3, Example 4, and Comparative Example 1 revealed that a high conversion efficiency was obtained when the TABI was added at concentrations of 4 mol%, 7.5 mol %, and 10 mol %, and in particular, even higher conversion efficiency was obtained when the concentration was 5 mol% and 7.5 mol%. As show in FIG. 6, the photoelectric conversion elements of Example 1, 3, and 4 each had an open-circuit voltage significantly increased in comparison with that of the photoelectric conversion element of Comparative Example 1. As a result, the photoelectric conversion elements of Examples 1, 3, and 4 each can achieve a conversion efficiency higher than that of the photoelectric conversion element of Comparative Example 1. In particular, the photoelectric conversion elements of Examples 1 and 3 achieved a conversion efficiency higher by about 1% than that of the photoelectric conversion element of Comparative Example 1.

Comparison of Example 2, Example 5, Example 6, and Comparative Example 2 revealed that in a case of using TPAI and TAAI as the ammonium salt, similarly to the case of using the TBAI, the open-circuit voltage with respect to the photoelectric conversion element including a photoelectric conversion material free of ammonium salt was increased (see FIG. 7), indicating that a high conversion efficiency can be obtained. In comparison of Example 2, Example 5, and Example 6, the highest conversion efficiency was achieved when TBAI was used as the ammonium salt under the conditions for the present study.

As can be seen from Table 2 and FIG. 8, even in the case that TMAF was used as the ammonium salt, a high open-circuit voltage was obtained, and thus, high conversion efficiency was obtained.

### <PL lifetime evaluation of photoelectric conversion layer>

In order to measure the PL lifetime of the photoelectric conversion layer, a measurement sample was produced using the same procedures as for the photoelectric conversion layer of the photoelectric conversion element.

Specifically, a precursor solution of the photoelectric conversion layer was applied to a glass substrate by spin coating, followed by baking at 200°C, 220°C, or 240°C for 10 minutes. A single photoelectric conversion layer was formed in this manner. During the film formation by spin coating at 5000 rpm for 30 seconds, chlorobenzene being a poor solvent was supplied dropwise. Next, a UV-curable epoxy resin was applied to a periphery of the substrate, another glass substrate was placed thereon, and the resulting laminate was irradiated with UV. The epoxy resin was thereby cured to encapsulate the measurement sample.

The precursor solution of photoelectric conversion layer was obtained in the following manner. First, SnI₂ and CsI were added to a solvent mixture containing DMF and DMSO (at a volume ratio of 1:1) to prepare a 0.9 mol/L first solution. Next, SnF₂ was added to a solvent mixture containing DMF and DMSO (at a volume ratio of 1:1) to prepare a 0.9 mol/L second solution. Further, TBAI was added to a solvent mixture containing DMF and DMSO (at a volume ratio of 1:1) to prepare a 0.9 mol/L third solution.

The second solution was added to the first solution so as to obtain a precursor solution including CsSnI₃ and also SnF₂ at a concentration to CsSnI₃ of 16 mol%. Further, the second solution and the third solution were added to the first solution so as to obtain a precursor solution including CsSnI₃, SnF₂ at a concentration to CsSnI₃ of 16 mol%, and TBAI at a concentration to CsSnI₃ of 5 mol%.

The PL lifetime was measured using a near-infrared fluorescence lifetime measurement system (C7990VIS/NIR manufactured by Hamamatsu Photonics K.K.). The photo sensor module used in the component equipment was the H7422. The measurement results were analyzed using the fluorescence lifetime software U8167-03.

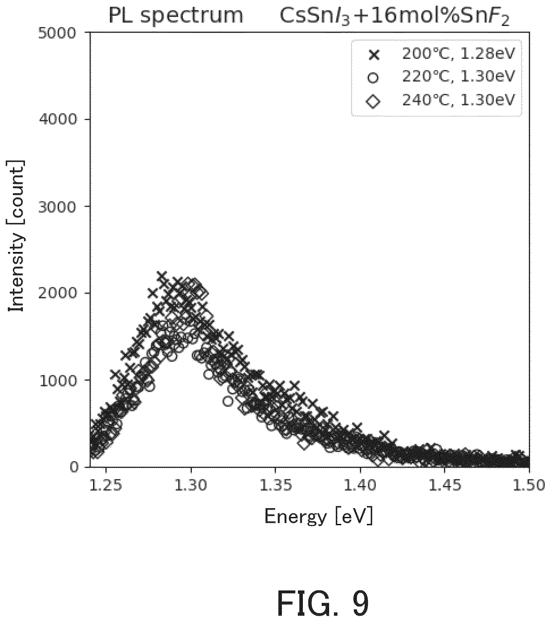

FIG. 9 is a graph showing a PL spectrum of a single photoelectric conversion layer made of CsSnI₃ + 16 mol% SnF₂.

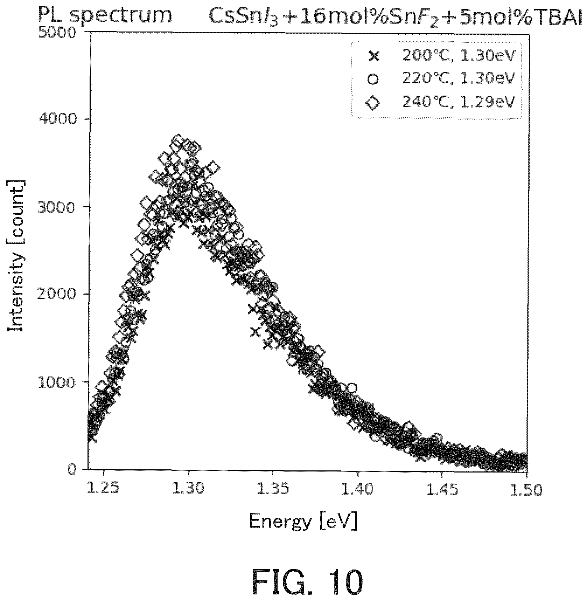

FIG. 10 is a graph showing a PL spectrum of a single photoelectric conversion layer made of CsSnI₃ + 16 mol% SnF₂ + 5 mol% TBAI.

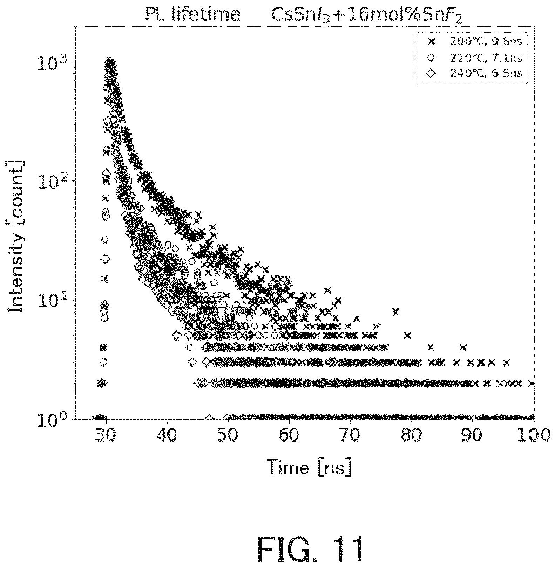

FIG. 11 is a graph showing a PL lifetime of a single photoelectric conversion layer made of CsSnI₃ + 16 mol% SnF₂.

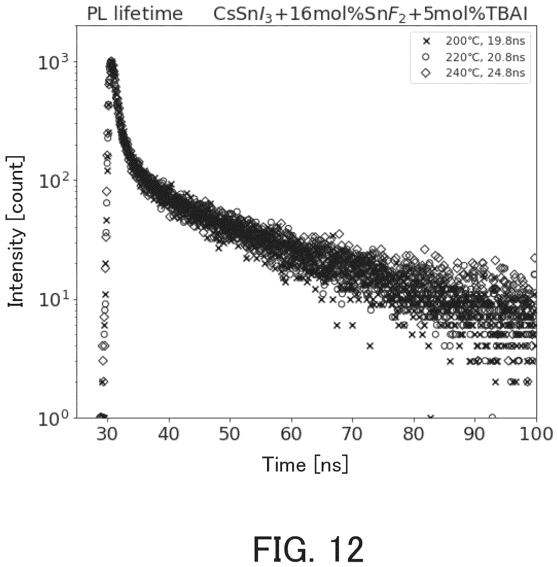

FIG. 12 is a graph showing a PL lifetime of a single photoelectric conversion layer made of CsSnI₃ + 16 mol% SnF₂ + 5 mol% TBAI.

FIG. 9 shows that the PL peak of the single photoelectric conversion layer made of CsSnI₃ + 16 mol% SnF₂ was from 1.28 eV to 1.30 eV. Further, FIG. 10 shows that the PL peak of a single photoelectric conversion layer obtained by adding a solution including TBAI at a concentration of 5 mol% to CsSnI₃ + 16 mol% SnF₂ was from 1.29 eV to 1.30 eV. This result shows that the band gap was almost unaltered before and after the addition of TBAI. That is, it was confirmed that the perovskite compound CsSnI₃ was maintained as it was even after addition of the TBAI, and the crystal structure did not change.

As evidently shown from the comparison between the PL lifetime shown in FIG. 11 and the PL lifetime shown in FIG. 12, addition of the TBAI at a concentration of 5 mol% to the CsSnI₃ + 16 mol% SnF₂ served to significantly extend the PL lifetime of a photoelectric conversion material from the range of 6.5 to 9.6 ns to the range of 19.8 ns to 24.8 ns.

### <Evaluation of SEM image of photoelectric conversion layer>

A photoelectric conversion layer was formed on a porous layer prepared in the same manner as in Example 1.

Specifically, a precursor solution of photoelectric conversion layer was applied by spin coating to a glass substrate provided up to the porous layer thereon, followed by baking at 180°C for 10 minutes so as to form a single layer. During the film formation by spin coating at 5000 rpm for 30 seconds, chlorobenzene being a poor solvent was supplied dropwise.

The precursor solution of photoelectric conversion layer was obtained in the following manner. First, SnI₂ and CsI were added to a solvent mixture liquid containing DMF and DMSO (at a volume ratio of 1:1) to prepare a 0.9 mol/L first solution. Next, SnF₂ was added to a solvent mixture containing DMF and DMSO (at a volume ratio of 1:1) to prepare a 0.9 mol/L second solution. Further, TBAI was added to a solvent mixture containing DMF and DMSO (at a volume ratio of 1:1) to prepare a 0.9 mol/L third solution.

The second solution was added to the first solution so as to obtain a precursor solution of CsSnI₃ + 16 mol% SnF₂. Further, the second solution and the third solution were added to the first solution so as to obtain a precursor solution of CsSnI₃ + 16 mol% SnF₂ + 5 mol% TBAI.

SEM photographs were taken using a field emission type scanning electron microscope (SU8200 manufactured by Hitachi High-Tech Corporation).

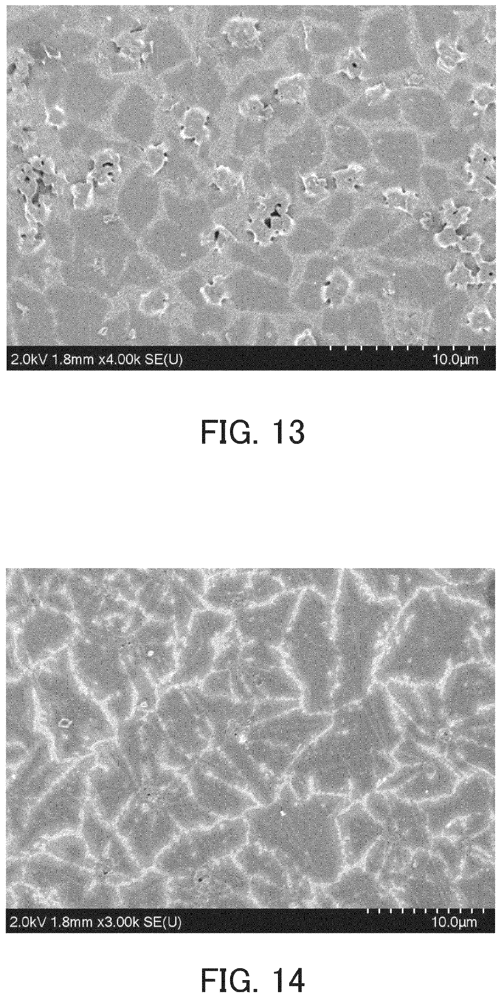

FIG. 13 is a SEM photograph taken from above of a photoelectric conversion layer made of a precursor solution of CsSnI₃ + 16 mol% SnF₂.

FIG. 14 is a SEM photograph taken from above of a photoelectric conversion layer made of a precursor solution of CsSnI₃ + 16 mol% SnF₂ + 5 mol% TBAI.

As evidently shown from comparison between the SEM photograph of FIG. 14 and the SEM photograph of FIG. 13, the particle diameter of crystals of the photoelectric conversion material including TBAI (FIG. 14) was larger than the particle diameter of crystals of the photoelectric conversion material free of TBAI (FIG. 13). It is believed that, in this manner, the addition of TBAI can increase the particle diameter of the crystals, thereby reducing the crystal grain boundaries in the photoelectric conversion material and reducing carrier recombination. Therefore, it is believed that the photoelectric conversion material to which the TBAI was added improved its photoelectric conversion efficiency.

Further, in a time-of-flight secondary ion mass spectrometry (TOF-SIMS) performed on the photoelectric conversion layer, TBA⁺ was detected in the film thickness direction. Furthermore, in the case where a film was formed by mixing only TBAI and SnI₂ and subjected to a measurement using X-ray diffraction (XRD), no peak was detected, suggesting that TBASnI₃ crystals were not formed. Therefore, it is presumed that in the photoelectric conversion layer prepared in Examples, the ammonium salt is present without being incorporated into the crystals.

### INDUSTRIAL APPLICABILITY

The photoelectric conversion material of the present disclosure can be used, for example, in a solar cell.

## Claims

1. A photoelectric conversion material comprising a perovskite compound and an ammonium salt.

2. The photoelectric conversion material according to claim 1, wherein
the photoelectric conversion material has a photoluminescence peak energy of less than 1.55 eV.

3. The photoelectric conversion material according to claim 1 or 2, wherein
the perovskite compound has an average primary particle diameter of 2 µm or more.

4. The photoelectric conversion material according to any one of claims 1 to 3, wherein
a photoluminescence peak energy of the photoelectric conversion material is substantially the same as a photoluminescence peak energy of the perovskite compound.

5. The photoelectric conversion material according to any one of claims 1 to 4, wherein
the ammonium salt includes at least one selected from the group consisting of an alkyl group and an aryl group.

6. The photoelectric conversion material according to claim 5, wherein
the ammonium salt includes the alkyl group, and
the alkyl group has 1 or more and 10 or less carbon atoms.

7. The photoelectric conversion material according to any one of claims 1 to 6, wherein
the ammonium salt includes a quaternary ammonium salt.

8. The photoelectric conversion material according to any one of claims 1 to 7, wherein
the ammonium salt includes a halogen element.

9. The photoelectric conversion material according to claim 8, wherein
the ammonium salt includes an iodine-containing ammonium salt.

10. The photoelectric conversion material according to claim 9, wherein
the iodine-containing ammonium salt is at least one selected from the group consisting of tetrapropylammonium iodide, tetrabutylammonium iodide, tetraamylammonium iodide, tetrahexylammonium iodide, and tetraheptylammonium iodide.

11. The photoelectric conversion material according to any one of claims 8 to 10, wherein
the ammonium salt includes a fluorine-containing ammonium salt.

12. The photoelectric conversion material according to claim 11, wherein
the fluorine-containing ammonium salt is at least one selected from the group consisting of tetramethylammonium fluoride and tetrabutylammonium fluoride.

13. The photoelectric conversion material according to any one of claims 1 to 12, wherein
a molar ratio of the ammonium salt to the perovskite compound is 0.01 or more and 0.50 or less.

14. The photoelectric conversion material according to claim 13, wherein
the molar ratio is 0.05 or more and 0.10 or less.

15. The photoelectric conversion material according to any one of claims 1 to 14, wherein
the perovskite compound includes a halogen anion.

16. The photoelectric conversion material according to any one of claims 1 to 15, wherein
the perovskite compound is made of a monovalent cation, a divalent cation, and a halogen anion, and
the divalent cation includes at least one selected from the group consisting of a Sn cation, a Ge cation and a Pb cation.

17. The photoelectric conversion material according to claim 16, wherein
the monovalent cation includes an inorganic cation at a concentration of 50 mol% or more.

18. The photoelectric conversion material according to claim 16 or 17, wherein
the perovskite compound is at least one selected from the group consisting of CsSnls, CsGeI₃, and CsPbI₃.

19. The photoelectric conversion material according to any one of claims 1 to 18, further comprising SnF₂.

20. A photoelectric conversion element comprising:
a first electrode;
a photoelectric conversion layer; and
a second electrode, wherein
the photoelectric conversion layer includes the photoelectric conversion material according to any one of claims 1 to 19.
